## Europäisches Patentamt
## European Patent Office
## Office européen des brevets

(19)

(11) Veröffentlichungsnummer: **0 019 064**
**B1**

(12)

# EUROPÄISCHE PATENTSCHRIFT

(45) Veröffentlichungstag der Patentschrift:
28.07.82

(51) Int. Cl.³: **C 25 F 3/14,** C 23 F 1/02, B 23 K 26/00

(21) Anmeldenummer: 80101628.8

(22) Anmeldetag: 27.03.80

(54) Verfahren zur selektiven chemischen oder elektrochemischen abtragenden Bearbeitung.

(30) Priorität: 08.05.79 US 37074

(43) Veröffentlichungstag der Anmeldung:
26.11.80 Patentblatt 80/24

(45) Bekanntmachung des Hinweises auf die Patenterteilung:
28.07.82 Patentblatt 82/30

(84) Benannte Vertragsstaaten:
BE CH DE FR GB NL SE

(56) Entgegenhaltungen:
FR-A-2 300 632

(73) Patentinhaber: International Business Machines
Corporation, Armonk, N.Y. 10504 (US)

(72) Erfinder: Melcher, Robert Lee, 2139 Vista Court,
Yorktown Heights, N.Y. 10598 (US)
Erfinder: Romankiw, Lubomyr Taras, 7 Dunn Lane,
Briarcliff Manor, N.Y. 10510 (US)
Erfinder: von Gutfeld, Robert Jacob, 600 West 115th St.,
N.Y. 10025 (US)

(74) Vertreter: Schröder, Otto H., Dr.-Ing., c/o International
Business Machines Corporation Zurich Patent
Operations Säumerstrasse 4, CH-8803 Rüschlikon/ZH
(CH)

ACTORUM AG

## Verfahren zur selektiven chemischen oder elektrochemischen abtragenden Bearbeitung

Die Erfindung betrifft ein Verfahren zur selektiven chemischen oder elektrochemischen abtragenden Bearbeitung von ausgewählten Gebieten der Oberfläche eines Werkstücks, wobei das Werkstück sich in einem Gefäss mit einer Ätzlösung bzw. mit einem Elektrolyten und mit einer separaten Kathode befindet.

Die klassischen Methoden der abtragenden Oberflächenbearbeitung basieren auf mechanischer Deformation wie beispielsweise die spanabhebende Bearbeitung. Sie sind daher in ihrer Feinheit begrenzt und hinterlassen oft Bearbeitungsspuren. Deformationen der bearbeiteten Oberfläche werden zum Teil dadurch vermieden, dass man chemische oder elektrochemische Verfahren verwendet.

In dem Journal of Electrochemical Society, „Elektrochemical Technology", Band 118, Nr. 10, Seiten 1699 bis 1704 beschreiben W. Kern und J. M. Shaw ein Verfahren, um Muster hoher Auflösung in dünne Schichten von Wolfram zu zeichnen, die sich auf Halbleiterplättchen befinden. Ihr Verfahren gründet sich auf eine schnelle anodische Auflösung von Wolfram. Damit diese Auflösung nur in bevorzugten Gebieten erfolgt, ist es notwendig, vorher eine Maske aus Photolack aufzubringen. Der Photolack wird selektiv belichtet und durch Entwicklung ein Muster gebildet, die belichteten Gebiete werden dann elektrochemisch bearbeit und schliesslich muss die Maske von dem Werkstück entfernt werden. Das Verfahren umfasst daher mehrere Schritte, die sowohl viel Zeit verbrauchen als auch kostspielig in der Ausführung sind.

Es gibt auch maskenlose Verfahren für die elektrochemische abtragende Bearbeitung. Beispielsweise wird eine Kathode besonderer Form in enge Nachbarschaft zu dem Werkstück gebracht, welches als Anode dient. Eine zwischen Kathode und dem Werkstück durchfliessende Salzlösung dient als Elektrolyt. Wenn eine Spannung angelegt wird, um das Werkstück bezüglich der Kathode anodisch zu machen, dann werden Metallionen von dem Werkstück in die Flüssigkeit vorzugsweise in der Nähe der Kathode transferiert. Mit der zunehmenden Veränderung der Oberfläche des Werkstückes wird die Kathode nachgeführt, um den notwendigen geringen Abstand zum Werkstück aufrecht zu erhalten. Dieses Verfahren ist geeignet, um flache Einsenkungen in einer Oberfläche herzustellen. Diese sind meistens axialsymmetrisch und die Möglichkeiten des Verfahrens sind begrenzt. Auch sind Pumpeinrichtungen notwendig, um den Elektrolyten zwischen Werkstück und Kathode rasch hindurchströmen zu lassen, damit er unlösliche Reaktionsprodukte wegspült und gleichzeitig die Elektroden kühlt. Weitere Oberflächenbearbeitungsverfahren, die ohne Maske arbeiten, werden auch durch J. F. Thorpe und R. D. Zerkle in einem Artikei beschrieben mit dem Titel „Theoretical Analysis of the Equilibrium Sinking of Shallow, Axially Symmetric Cavities by

Electrochemical Machining". W. König und J. Degenhardt veröffentlichten einen Artikel „The Influence of Process Parameters and Tool-Electrode Geometry on the Development of the Overcut in Electrochemical Machining with High Current Densities". Beide Artikel sind veröffentlicht in den Fundamentals of Electrochemical Machining, (1971), herausgegeben von C. L. Faust, Electrochemical Society, Princeton, New Jersey.

Es ist bekannt, mit Laserstrahlen feine Löcher zu bohren. Da bei diesem Verfahren das abzutragende Material geschmolzen oder verdampft wird, wird das Werkstück lokal ausserordentlich stark erhitzt. Dadurch können Veränderungen der Feinstruktur verursacht werden, so dass das Werkstück durch verbliebene Spannungen oder Risse geschädigt wird. Auch leidet die Kantenschärfe durch das Verdampfen oder das Wegschmelzen von Material. Solche Probleme werden in dem Artikel „Effect of Pulsed Laser Radiation on Thin Aluminum Foils" durch M. O. Aboelfotoh und R. J. von Gutfeld diskutiert, welcher Artikel im Journal of Applied Physics, Band 43, Nr. 9, (1972) auf den Seiten 3789 bis 3794 erschienen ist.

Es ist ein Ziel der Erfindung, maskenlose Verfahren zur selektiven chemischen oder elektrochemischen abtragenden Bearbeitung von Oberflächen entscheidend zu verbessern. Das neue Verfahren soll geeignet, sein, integrierte Schaltungskreise auf dem Halbleiterplättchen zu verändern. Ein weiteres Ziel der Erfindung ist ein Verfahren der genannten Art, das die Herstellung von willkürlich geformten Profilen ermöglicht.

Gemäss der Erfindung ist das Verfahren der eingangs genannten Art dadurch gekennzeichnet, dass man einen scharf gebündelten Strahl elektromagnetischer Energie auf das Werkstück richtet, wobei Gebiete der Oberfläche selektiv aufgeheizt werden, wodurch dort die Reaktion beschleunigt wird und diese Gebiete bevorzugt abgetragen werden.

Die Erfindung wird anhand von Ausführungsbeispielen mit Hilfe der Zeichnungen näher erläutert.

Fig. 1   zeigt schematisch ein erstes Ausführungsbeispiel, wie man einen Strahl elektromagnetischer Energie dazu verwenden kann, um selektive chemische abtragende Bearbeitung eines Werkstücks zu verbessern.

Fig. 2   zeigt schematisch ein zweites Ausführungsbeispiel, wie man einen Strahl elektromagnetischer Energie dazu verwenden kann, um selektive elektrochemische abtragende Bearbeitung einer Oberfläche zu verbessern.

Mit Hilfe des Verfahrens wird die Anwendung von Masken überflüssig. In einem Falle wird das zu bearbeitende Werkstück mit einer Ätzlösung in Kontakt gebracht. Ein scharf gebündelter Strahl elektromagnetischer Energie wird auf das Werkstück dort gerichtet, wo durch eine lokale Aufheizung die chemische Reaktion beschleunigt werden soll. So wird der Ätzprozess beschleunigt und das Material bevorzugt aus den bestrahlten Gebieten abgetragen.

Im anderen Falle wird das Werkstück in einen Elektrolyten verbracht, in welchem sich auch eine Kathode befindet. Auch hier wird ein scharf gebündelter Strahl elektromagnetischer Energie auf das Werkstück dorthin gerichtet, wo durch lokale Aufheizung der Abtragungsprozess beschleunigt werden soll. In diesem Falle dient das Werkstück gleichzeitig als Anode. Eine entsprechende Spannung wird an die Elektroden angelegt, d.h. an die separate Kathode und an das als Anode dienende Werkstück.

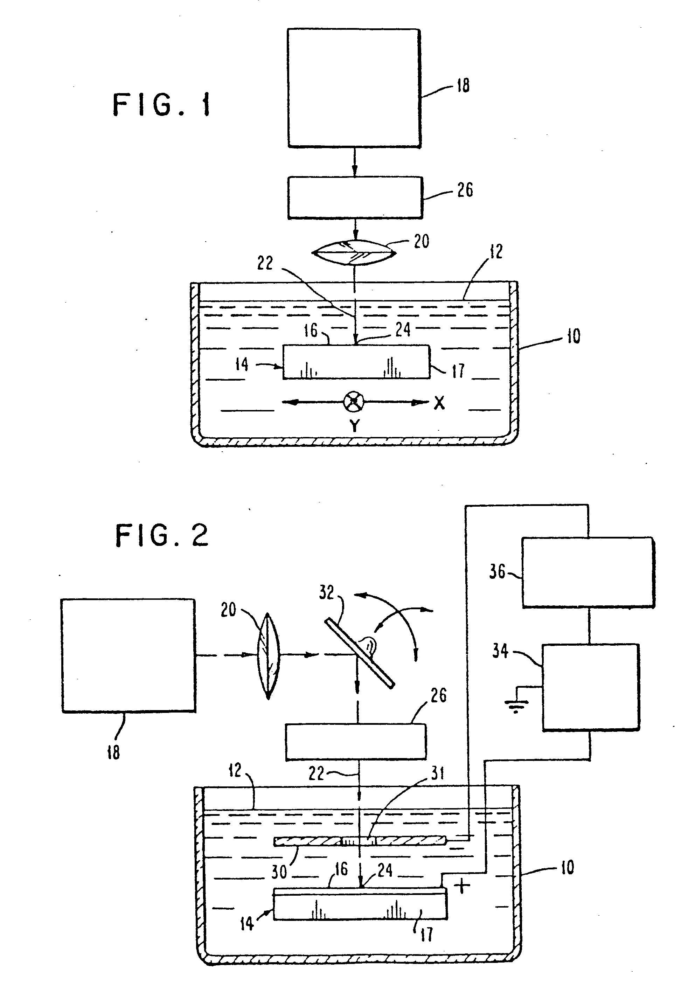

In der Fig. 1 enthält ein Gefäss 10 eine Ätzlösung 12. Ein Werkstück 14 ist in die Ätzlösung 12 so getaucht, dass seine chemisch zu bearbeitende Oberfläche durch die Lösung benetzt wird. In der Zeichnung ist das Werkstück 14 in horizontaler Lage dargestellt. Seine zu bearbeitende Oberfläche 16 kann jedoch auch senkrecht stehen oder sich in irgend einer anderen Lage befinden. Die Ätzlösung kann basisch oder auch sauer sein. Jedenfalls sollte eine solche Ätzlösung gewählt werden, welche bei Raumtemperatur das Werkstück nur wenig oder garnicht angreift. Auch sollte die Arbeitsweise der Ätzlösung so sein, dass die zu bearbeitende Oberfläche 16 nur sehr gleichmässig angegriffen wird, d.h. nicht selektiv in der Form, dass beispielsweise die Korngrenzen bevorzugt angegriffen werden.

Für solche Metalle wie Nickel, Kupfer oder Aluminium ist eine saure Ätzlösung zweckmässig, die beispielsweise $HNO_3$, $HCl$ oder $H_3PO_4$ enthält.

Wenn das Werkstück 14 in die Ätzlösung 12 eingetaucht ist, erfolgt ein allgemeines mildes Ätzen an allen benetzten Flächen einschliesslich der Oberfläche 16, was hier als Hintergrundätzen bezeichnet werden soll. Durch ein Linsensystem 20 wird ein von einer Strahlungsquelle 18 ausgehender Strahl 22 scharf gebündelt, so dass er die Ätzlösung 12 durchdringt und auf die Oberfläche 16 einfällt. Die Strahlungsquelle 18 erzeugt elektromagnetische Strahlung im sichtbaren Gebiet oder im infraroten Bereich des Spektrums. Die Wellenlänge sollte so gewählt werden, dass die Strahlung durch die Ätzlösung 12 nicht stark absorbiert wird, jedoch von dem Werkstück 14 stark absorbiert wird. Wenn man feine Löcher in das Werkstück bohren will, deren Durchmesser nicht grösser als 100 μm ist, dann sollte vorzugsweise die Dicke des Werkstücks 14 nicht grösser als 0,127 mm sein. Dadurch wird sichergestellt, dass die Ätzlösung in den abgetragenen Gebieten sich mit dem Rest der Lösung mischt.

Das Verfahren der chemischen abtragenden Bearbeitung ist besonders für ein Werkstück 14 geeignet, das zusammengesetzter Struktur ist, wobei die zu bearbeitende Oberfläche 16 aus einem Material besteht, das stark optische Strahlung absorbiert, wie beispielsweise ein Metall, und dass der Rest des Werkstückes ein Substrat 17 aus einem Material mit geringer Wärmeleitfähigkeit ist wie beispielsweise Glas. Eine solche Struktur des Werkstückes 14 ist in der Fig. 2 dargestellt. Die Lokalisierung des aufgeheizten Gebietes wird dadurch verbessert und damit auch die Kantenschärfe des bevorzugt geätzten Gebietes. Aus den genannten Gründen sollte die Metallschicht 16 möglichst dünn sein, vorzugsweise dünner als 0,127 mm, wenn Vertiefungen mit einem Durchmesser kleiner als 100 μm erwünscht sind.

Der Strahl 22 belichtet das Gebiet 24 und heizt dadurch lokal Stellen der Oberfläche 16 auf, wo eine chemische Bearbeitung durch Materialabtragung erwünscht ist. Der Strahl 22 kann ortsfest ausgerichtet sein und man erzeugt Muster dadurch, dass man das Werkstück 14 in seiner Ebene in den Koordinatenrichtungen X und Y entsprechend verschiebt. In der Fig. 1 ist das durch die eingezeichneten Pfeile bzw. Achsenrichtungen mit den Bezeichnungen X und Y angedeutet. Anderseits kann man auch das Werkstück 14 ortsfest anordnen und den Strahl 22 mit einer entsprechenden Abtastbewegung steuern.

Wenn elektromagnetische Strahlung im sichtbaren Bereich verwendet wird, kann als Strahlungsquelle ein Kohlelichtbogen ausreichend sein. Vorzugsweise verwendet man jedoch als Strahlungsquelle einen Laser wie beispielsweise einen Multimoden-Argonlaser oder einen abstimmbaren Kryptonlaser. Wenn die Intensität des Lasers als Strahlungsquelle 18 hoch genug ist, kann man auf die Anordnung eines Linsensystems 20 verzichten, vorausgesetzt, der Strahl 22 ist bereits ausreichend scharf gebündelt. Die Energiedichte des Brennflecks sollte zwischen $10^2$ und $10^6$ W/cm² liegen.

Der untere Grenzwert sollte noch eine genügende Aufheizung bewirken, um die Ätzrate zu steigern, während der obere Grenzwert so gewählt werden sollte, dass keine Strukturveränderungen des Werkstückes durch die Wärmebehandlung bewirkt werden. Im allgemeinen wird dadurch das Maximum der Energiedichte auf einen Wert von etwa $10^6$ W/cm² begrenzt. Wenn der Strahl 22 längere Wegstrecken durch die Ätzlösung 12 durchläuft, muss man darauf achten, dass man Wellenlängen der Strahlung vermeidet, welche durch die Ätzlösung 12 stark absorbiert werden.

Man kann auch die Anordnung so treffen, dass der Strahl 22 die Ätzlösung 12 nicht durchlaufen muss. Wenn beispielsweise nur die Oberfläche 16 des Werkstückes 15 in Kontakt mit der Ätzlösung 12 gebracht wird, dann kann der Strahl 22 das Werkstück 14 auch von der Rückseite her belichten. Wenn die Dicke des Werkstückes 14 in den Bereichen, wo eine Oberflächenbearbeitung erfolgen soll, nicht grösser als 0,127 mm ist, dann kann man auch scharfe Temperaturprofile durch das Werkstück 14 hindurch erzielen, so dass die Umrisse der aufgeheizten Gebiete der Oberfläche 16 praktisch die gleichen wie an der Rückseite sind. Das gleiche Verfahren kann auch für ein dickeres Werkstück 14 angewendet werden, das eine stark absorbierende Oberfläche 16 hat, beispielsweise eine dünne Metallschicht, die auf einem Substrat 17 angeordnet ist, welches für Strahlung durchlässig ist. In diesem Falle sollte die Metallschicht dünner als 0,127 mm sein, wenn man Einsenkungen erreichen will, die in der Grössenordnung von 100 $\mu$m liegen.

Der von der Strahlungsquelle 18 gelieferte Strahl 22 kann durch einen Strahlmodulator 26 moduliert werden, der zwischen der Strahlungsquelle 18 und dem Linsensystem 20 oder zwischen dem Linsensystem 20 und dem Werkstück 14 angeordnet ist. Der Strahlmodulator 26 kann ein mechanischer Zerhacker sein, wenn die Modulationsfrequenz niedrig ist, oder ein optischer Modulator, falls die Modulationsfrequenz höher liegt. Elektrooptische Modulatoren sind bis zum Bereich von einigen Gigahertz arbeitsfähig.

In der durch das einfallende Licht aufgeheizten Gebieten 24 erfolgt ein bevorzugtes Ätzen. Moduliertes oder gepulstes Licht bewirkt schärfer ausgeprägte Temperaturprofile an den Grenzen der belichteten Gebiete 24, wodurch die Ätzrate und die Kantenschärfe gesteigert wird.

Durch die Modulation des Laserlichtes wird auch die Ausbreitung der Wärme im Substrat begrenzt, womit die Auflösung von Bearbeitungsmustern verbessert wird.

Ein Beispiel für eine Einrichtung für ein Verfahren zur elektrochemischen abtragenden Bearbeitung einer Oberfläche ist in der Fig. 2 dargestellt. Ein Gefäss 10 enthält eine Flüssigkeit, die in diesem Falle ein Elektrolyt 12 ist. Bei dem Bearbeiten von Metallen wie Chrom, Nickel oder Titan ist der Elektrolyt zweckmässig eine Kochsalzlösung.

Das Werkstück 14 befindet sich eingetaucht im Elektrolyten 12. In diesem Falle muss das Werkstück 14 elektrisch leitend sein und besteht deshalb aus einem Metall, einem Photoleiter oder aus einer zusammengesetzten Struktur aus einem Isolator mit einem elektrischen Leiter. Im Falle einer zusammengesetzten Struktur mit einem nichtleitenden Substrat hat vorzugsweise die metallisierte Oberfläche 16 eine Dicke kleiner als 0,127 mm. In dem Elektrolyten 12 ist eine Kathode 30 im Abstand von dem Werkstück 14, das gleichzeitig als Anode dient, angeordnet. Die Strahlung einer Strahlungsquelle 18 wird durch ein Linsensystem 20 zu einem Strahl 22 fokussiert, der eine Öffnung 31 in der Kathode 30 durchläuft und das Gebiet 24 auf der zu bearbeitenden Oberfläche 16 belichtet. Falls ein Laser eine ausreichend starke Strahlungsquelle 18 bildet, kann auf das Linsensystem 20 verzichtet werden. Der Strahl 22 kann auf der zu bearbeitenden Oberfläche 16 eine Abtastbewegung ausführen, die durch relative Bewegung des Strahls oder des Werkstücks erfolgt. In Fig. 2 ist ein Abtastspiel 32 für die Steuerung des Strahls 22 vorgesehen, um einen vorbestimmten Teil der Oberfläche 16 des Werkstückes 14 zu belichten.

Auch andere Anordnungen sind möglich, wo der Strahl 22 keine oder nur geringe Strecken durch den Elektrolyten 12 durchläuft. Eine Spannungsquelle 34 ist mit dem Werkstück 14 und mit der Kathode 30 verbunden. Bezüglich des Werkstuckes 14 wird die Kathode auf einem negativen Potential gehalten. Auch hier kann der Strahl 22 durch einen Strahlmodulator 26 moduliert sein, um das Temperaturprofil in dem der Strahlung ausgesetzten Gebiet 24 schärfer auszubilden und dadurch die Auflösung der Oberflächenbearbeitung zu verbessern. Ein Spannungsmodulator 36 kann dazu verwendet werden, die Zufuhr der elektrischen Spannung mit der Modulation des Strahles zu synchronisieren. Diese Synchronisation hat den Vorteil, dass das Ätzen nur dann erfolgen darf, wenn der Laser das Substrat lokal aufgeheizt hat und so den optimalen Temperaturgradienten zur Verfügung stellt. In den übrigen Zeiten des Modulationszyklus wird die zugeführte Spannung abgeschaltet, womit ein Ätzen des Hintergrundes vermieden wird.

Wenn die Spannung in dem Sinne wie beschrieben angelegt ist, wandern Metallionen von dem Werkstück 14 in den Elektrolyten 12. Dieser Transport der Ionen erfolgt vorzugsweise in dem Gebiet 24, das durch die einfallende Strahlung aufgeheizt wird. Durch entsprechendes Pulsen des Lichtes und synchrones Pulsen der Spannung ist es möglich, Ätzraten zu erhalten, die etwa $10^4 \times$ grösser sind als die Ätzraten in den Hintergrundgebieten. Um Ätzmuster in der Oberfläche des Werkstückes von genügender Auflösung zu erhalten, ist es daher nicht mehr notwendig, eine Maske zu benutzen.

Bisher wurden alle Verfahren so dargestellt, dass ein einzelner Strahl 22 auf das Werkstück 14 einfällt. Selbstverständlich kann man auch mehrere Strahlen gleichzeitig benutzen und so gleichzeitig an mehreren Stellen ätzen.

Die folgenden spezielle Beispiele der Erfindung zeigen Einzelheiten. Sie dienen der Erläuterung der Erfindung und beschränken diese keinesfalls.

*Beispiel I*

Ein Werkstück aus rostfreiem Stahl und eine Kathode aus Plantin werden in eine Nickelchlorid-Ätzlösung eingebracht. Die Lösung hat die folgende Zusammensetzung:

| | |
|---|---|
| 21 g | $NiCl_2 \cdot 6\,H_2O$ |
| 25 g | $H_3BO_3$ |
| 1,64 g | Na-Saccharin |
| 1,0 g | 2 butyn-1-4-diol |
| 1 l | $H_2O$ |

Die Oberfläche des Werkstückes ist benachbart, jedoch getrennt von der Kathode und hat eine Flächenausdehnung von etwa 0,3 cm². Die Anode, d.h. das Werkstück, und die Kathode werden auf einer konstanten Potentialdifferenz gehalten. Der dadurch bedingte Strom im Elektrolyten ist in der Grössenordnung von 1 mA, was einer Stromdichte von 3,3 mA/cm² entspricht. Ein Argonlaser fokussiert seinen Strahl auf das Werkstück mit einer Energiedichte von $3 \times 10^5$ W/cm². Der kreisrunde Brennfleck hat einen Durchmesser von etwa 50 $\mu$m. Die Impulsdauer ist 20 ms. Die Zeit zwischen den Laserimpulsen beträgt 60 ms. Während der Dauer der Laserimpulse steigt der Strom auf etwa 2 mA an. Bezogen auf den Brennfleck beträgt die Stromdichte $5,0 \times 10^4$ mA/cm². Aus diesem Anstieg der Stromdichte kann man entnehmen, dass die dazu proportionale Ätzrate um einen Faktor von etwa $1,5 \times 10^4$ zunimmt.

*Beispiel II*

Wenn 0,05 mm starkes Blech aus rostfreiem Stahl in den Elektrolyten eingebracht und wie in Beispiel I beschrieben belichtet wird, werden durchgehende Löcher in dem Blech erzeugt, wenn die Potentialdifferenz zwischen Anode und Kathode 1,5 V beträgt. In einer effektiven Belichtungszeit von etwa 9 s werden Löcher mit einem Durchmesser zwischen 25 und 50 $\mu$m mit scharfen Rändern erzeugt. In den Gebieten ausserhalb der Löcher zeigt das Blech keine Schädigungen.

*Beispiel III*

Ein stärkeres Blech der Dicke 0,5 mm aus rost freiem Stahl wird in den Elektrolyten der Beispiele I und II eingebracht. Die gleiche Spannung wird angelegt wie in den obigen Beispielen. Ein Argonlaser wird verwendet. Der Strahl ist auf einen Brennfleck von 150 $\mu$m Durchmesser fokussiert, was eine Energiedichte von etwa $2 \times 10^3$ W/cm² ergibt. Mit dem strahlungsunterstützen Ätzverfahren wurden Vertiefungen in verschiedenen Zeitperioden hergestellt, wobei die Belichtung kontinuierlich blieb. Die folgende Tabelle ergibt die Versuchswerte.

| Belichtungszeit (s) | Ätztiefe ($\mu$m) | Durchmesser ($\mu$m) |
|---|---|---|
| 2,5 | 4,8 | 160 |
| 5,0 | 8,0 | 160 |
| 10,0 | 16,0 | 175 |
| 15,0 | 18,3 | 175 |

Daraus ist ersichtlich, dass mit zunehmender Belichtungszeit die Ätztiefe wächst.

*Beispiel IV*

Eine Probe Blech aus rostfreiem Stahl gleicher Art wie in Beispiel III wird einem Strahl ausgesetzt, wie es im Beispiel III beschrieben ist. Eine Spannung von 1,5 V wird an die Elektroden angelegt. In diesem Falle wird der Strahl gepulst, so dass das Licht 44 ms eingeschaltet und 130 ms ausgeschaltet ist. Die geätzte Vertiefung hat eine Tiefe von 18 $\mu$m und einen Durchmesser von 115 $\mu$m. Wenn man die Beispiele III und IV vergleicht, erkennt man, dass die Auflösung der Ätzung besser ist, wenn der Strahl gepulst ist.

*Beispiel V*

Das Werkstück ist ein Substrat aus Glas mit einer aufgedampften Schicht aus Nickel von 1000 Å Stärke. Das Werkstück wird in eine Lösung eingebracht, deren Zusammensetzung wie folgt ist:

| 20 g | NaCl |
|---|---|
| 2,5 ml | $H_2SO_4$ konzentriert |
| 125 ml | $H_2O$ |

Ein Kryptonlaser ist auf 6471 Å abgestimmt und seine Strahlleistung beträgt etwa 700 mW. Bei dieser allgemeinen Bestrahlung bleibt der Nickelfilm unverändert. Dann wird das einfallende Licht auf die Oberfläche 16 fokussiert, so dass sich ein Brennfleck von etwa 170 $\mu$m Durchmesser ergibt mit einer Energiedichte von $3 \times 10^3$ W/cm². In der Metallschicht werden Vertiefungen bzw. Löcher erzeugt, wenn die Strahlung mit Belichtungszeiten in der Grössenordnung von 1 bis 5 s einfällt. Ein Dünnerwerden der Schicht auf etwa die Hälfte ihrer Stärke wird beobachtet, wenn das Werkstück und der Strahl relativ zueinander mit einer Geschwindigkeit von etwa 2 mm/s bewegt werden. Wenn in dem Bad die saure Lösung durch reines Wasser ersetzt wird, hat die Wiederholung des Experimentes keinerlei Effekt auf die Metallschicht.

Das Verfahren zur selektiven chemischen oder elektrochemischen abtragenden Bearbeitung von ausgewählten Gebieten der Oberfläche eines Werkstücks ist gut geeignet für Anwendungen, wo man Muster grosser Auflösung erzeugen will aber nicht ein umständliches Verfahren mit einer Maske anwenden möchte. Das Verfahren ist daher gut geeignet, Bohrungen oder Durchbrüche herzustellen oder integrierte Schaltungen auf dem Chip selbst zu verändern oder zu reparieren. Besonders günstig ist das Verfahren, wenn man nur relativ kleine Gebiete aus einem grösseren Bereich herausätzen möchte.

**Patentansprüche**

1. Verfahren zur selektiven chemischen oder elektrochemischen abtragenden Bearbeitung von ausgewählten Gebieten der Oberfläche eines Werstücks, wobei das Werkstück sich in einem Gefäss mit einer Ätzlösung bzw. mit einem Elektrolyten und mit einer separaten Kathode befindet, dadurch gekennzeichnet, dass man einen scharf gebündelten Strahl elektromagnetischer Energie auf das Werkstück richtet, wobei Gebiete der Oberfläche selektiv aufgeheizt werden, wodurch dort die Reaktion beschleunigt wird und diese Gebiete bevorzugt abgetragen werden.

2. Verfahren nach Anspruch 1, dadurch gekennzeichnet, dass der Strahl durch einen Laser erzeugt wird und dass die Energiedichte des Leuchtflecks im Bereich von $10^2$ W/cm² bis $10^6$ W/cm² liegt.

3. Verfahren nach Anspruch 2, dadurch gekennzeichnet, dass der Laserstrahl moduliert wird.

4. Verfahren nach Anspruch 2, dadurch gekennzeichnet, dass die Dicke des Werkstückes an der Bearbeitungsstelle kleiner als 0,127 mm ist.

5. Verfahren nach Anspruch 1, dadurch gekennzeichnet, dass eine alkalische Ätzlösung verwendet wird.

6. Verfahren nach Anspruch 1, dadurch gekennzeichnet, dass eine saure Ätzlösung verwendet wird.

7. Verfahren nach Anspruch 3, dadurch gekennzeichnet, dass im Falle der elektrochemischen Bearbeitung die an Kathode und Werkstück angelegte Spannung synchron mit dem Laserstrahl moduliert wird.

8. Verfahren nach Anspruch 4, dadurch gekennzeichnet, dass die zu bearbeitende Fläche eine dünne Metallschicht ist, die auf einem Substrat aufgebracht ist.

## Revendications

1. Procédé pour le décapage sélectif par voie chimique ou électrochimique de certaines régions de la surface d'une pièce de travail, la pièce de travail étant placée dans un récipient contenant une solution de décapage ou un électrolyte et une cathode séparée, caractérisé en ce qu'un faisceau d'énergie électromagnétique est focalisé sur la pièce de travail, échauffant ainsi sélectivement des régions de la surface, ce qui accélère la réaction et décape ces régions de façon préférentielle.

2. Procédé selon la revendication 1, caractérisé en ce que le faisceau est généré par un laser et en ce que la densité d'énergie au foyer est comprise entre $10^2$W/cm² et $10^6$W/cm².

3. Procédé selon la revendication 2, caractérisé en ce que le faisceau laser est modulé.

4. Procédé selon la revendication 2, caractérisé en ce que l'épaisseur de la pièce de travail à l'endroit à traiter est plus petite que 0,127 mm.

5. Procédé selon la revendication 1, caractérisé en ce que la solution de décapage utilisée est alcaline.

6. Procédé selon la revendication 1, caractérisé en ce que la solution de décapage utilisée est acide.

7. Procédé selon la revendication 3, caractérisé en ce que, dans le cas d'un traitement électrochimique, la tension appliquée entre la cathode et la pièce de travail est modulée de façon synchrone avec le faisceau laser.

8. Procédé selon la revendication 4, caractérisé en ce que la surface à traiter est une couche de métal mince déposée sur un substrat.

## Claims

1. Chemical or electrochemical process for selectively removing material at the surface of a workpiece while the workpiece is placed in a receptacle containing an etching solution or an electrolyte and a separate cathode, characterized in that a focused beam (22) of electromagnetic energy is directed at the workpiece (14) thereby heating selected surface regions (24) and causing accelerated reaction and preferential etching in these regions.

2. Process as claimed in claim 1, characterized in that the beam (22) is generated by a laser (18) operated with an intensity of between $10^2$W/cm² and $10^6$W/cm² at the focal point.

3. Process as claimed in claim 2, characterized in that the laser beam is modulated (26).

4. Process as claimed in claim 2, characterized in that the thickness of the workpiece at the point where it is to be processed is less than 0.127 mm.

5. Process as claimed in claim 1, characterized in that an alkaline etching solution is used.

6. Process as claimed in claim 1, characterized in that an acid etching solution is used.

7. Process as claimed in claim 3, characterized in that, for the electrochemical process, the voltage applied between the cathode (30) and the workpiece (14) is modulated in synchronism with the laser beam.

8. Process as claimed in claim 4, characterized in that the surface to be processed is a thin metal layer deposited on a substrate.

FIG. 1

FIG. 2